# EUROPÄISCHE PATENTANMELDUNG

(11) **EP 1 349 168 A1**
(43) Veröffentlichungstag der Anmeldung: **01.10.2003**
(21) Anmeldenummer: 03003785.7
(22) Anmeldetag: 19.02.2003
(51) Int. Cl.: G11B 33/08, G11B 33/12, H05K 7/14, G06F 1/18

(54) **Festlegung einer Einschubbaugruppe in einem Einbaukäfig eines Computers**

(30) Priorität: 26.03.2002 DE 10213526
(71) Anmelder: Fujitsu Siemens Computers GmbH, 81739 München (DE)
(72) Erfinder: Neukam, Wilhelm, 86399 Bobingen (DE); Hein, Holger, 86199 Augsburg (DE)
(74) Vertreter: Epping Hermann & Fischer

(57) **Zusammenfassung**

Die Erfindung betrifft eine Anordnung zur Festlegung einer Einschubbaugruppe (6) in einem Einbaukäfig (5) eines Computers mittels Halteschienen (7) aus Kunststoff, die seitlich an die Einschubbaugruppe (6) angesteckt sind, und am Einbaukäfig (5) befestigten Führungsschienen (1), in welche die Halteschienen (7) einschiebbar sind und über federnde Elemente (2) und federnde Anschläge (11) an den Führungsschienen (1) festgelegt sind.

## Beschreibung

Festlegung einer Einschubbaugruppe in einem Einbaukäfig eines Computers.

Die Erfindung betrifft eine Anordnung zur Festlegung einer Einschubbaugruppe in einem Einbaukäfig eines Computers mittels Halteschienen aus Kunststoff, die seitlich an die Einschubbaugruppe ansteckbar sind.

Eine derartige Anordnung ist aus der Figur 1 der EP 0 834 880 A1 bekannt. Im Einbaukäfig liegen die Halteschienen in der Regel auf Lappen auf, die aus dem Einbaukäfig ausgestanzt und nach innen gebogen sind.

Ein Problem ist, daß diese Anordnung bei eingebauter Einschubbaugruppe zwischen Einbaukäfig und Halteschiene vertikal, horizontal und in Einschubrichtung gewisse Spielräume aufweist. Deswegen ist die Einschubbaugruppe nicht ausreichend im Einbaukäfig befestigt. Bei'Betrieb der Einschubbaugruppe treten dann aufgrund von Vibrationen Probleme auf, die einen einwandfreien Betrieb der Einschubbaugruppe stören. Vor allem bei neuen Festplattengenerationen mit immer größerer Spurdichte und Drehzahl machen sich derartige Probleme bemerkbar.

Das von den Herstellern der Einschubbaugruppen empfohlene Anschrauben der Einschubbaugruppe am Einbaukäfig ist unwirtschaftlich und nicht kundenfreundlich, da zum Anschrauben Zeit und Werkzeug benötigt wird. Andererseits kann durch heruntergefallene Schrauben im Computer ein Problem, wie z.B. ein Kurzschluß entstehen.

Der Erfindung liegt daher die Aufgabe zu Grunde, die Halteschienen, die an der Einschubbaugruppe befestigt sind, so im Einbaukäfig festzulegen, dass Vibrationen vermieden werden und dennoch eine einfache Montage gewährleistet ist.

Die Aufgabe wird erfindungsgemäß dadurch gelöst, daß am Einbaukäfig Führungsschienen aus Kunststoff vorgesehen sind, in welche die Halteschienen einsteckbar sind.

Die Länge und die Breite der Führungsschienen sind etwas größer als die der Halteschienen. Schneidet man die Führungsschiene durch ihre lange Seite, so bildet das Profil des Schnitts ein U. Dessen mittlerer Schenkel entspricht der Breite der Halteschiene. Die äußeren Schenkel des U's sind so kurz, daß bei eingeschobener Halteschiene die Führungsschiene die Einschubbaugruppe nicht berührt.

Die Führungsschienen weisen an jedem der drei Schenkel des U's, sowie am Ende der langen Seite federnde Elemente zur Lagezentrierung und zur Fixierung der Halteschienen auf. Ebenso können die federnden Elemente auch an der Halteschiene ausgebildet sein. Durch die Anordnung der federnden Elemente können bei idealer Fixierung der Einschubbaugruppe Vibrationen optimal absorbiert werden.

Eine zusätzliche Erhöhung der Absorption wird erzielt, in dem man für die Halteschienen und die Führungsschienen Kunststoffe mit unterschiedlichen Eigenfrequenzen verwendet. Dadurch dämpfen sich die Schienen gegenseitig und ein Verstärken oder Weiterleiten der Vibrationen wird vermieden.

Zur schnelleren und einfacheren Montage der Führungsschienen am Einbaukäfig sind an der Außenseite der Führungsschienen Zapfen vorgesehen, mit denen die Führungsschienen in entsprechende Löcher im Einbaukäfig eingesteckt werden können. Durch entsprechende Rippen auf den Zapfen, welche beim Einstecken verdrängt werden, wird ein spielfreier Sitz gewährleistet.

Aufgrund dieser Anordnung ist eine sehr einfache Ausgestaltung des Einbaukäfigs möglich, da alle zur Befestigung notwendigen Vorrichtungen an den Kunststoffschienen ausgebildet sind.

Weitere Einzelheiten und Ausgestaltungen der Erfindung sind in den Unteransprüchen angegeben.

Die Erfindung wird nachfolgend an einem Ausführungsbeispiel anhand der Zeichnung näher erläutert.

In den Zeichnungen zeigen:
- Figur 1: die Innenansicht einer Führungsschiene,
- Figur 2: die Außenansicht einer Führungsschiene,
- Figur 3: eine mit Führungs- und Halteschienen in einem Einbaukäfig eingebaute Einschubbaugruppe,
- Figur 4: die Innenansicht einer Führungsschiene mit aufgenommener Halteschiene,
- Figur 5: eine Einschubbaugruppe mit aufgesteckter Halte- und Führungsschiene.

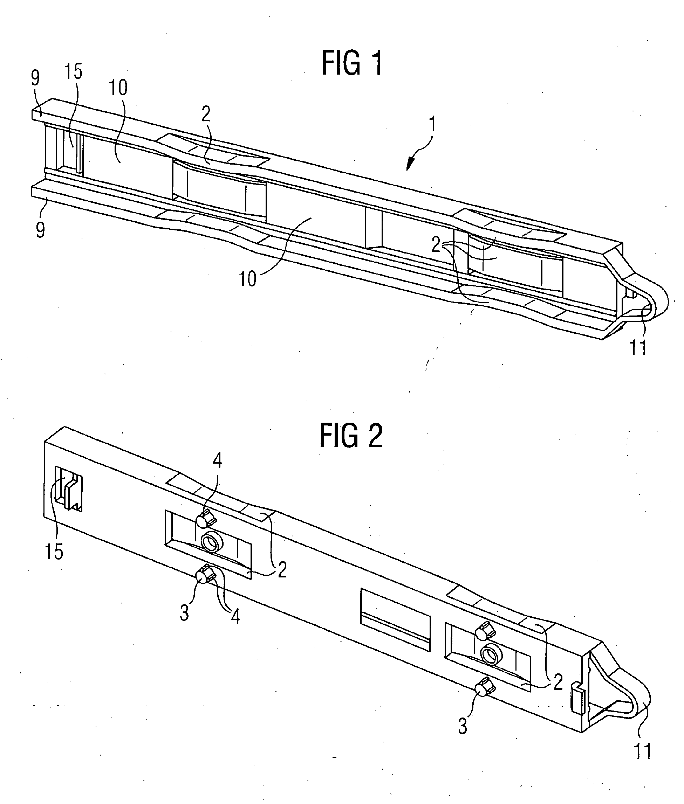

Figur 1 zeigt die Seite einer Führungsschiene 1 in die eine Halteschiene 7 eingeschoben werden kann.

An jedem Schenkel 9,10 der Führungsschiene befinden sich federnde Elemente 2, die einstückig mit der Führungsschiene 1 hergestellt sind, so dass die eingeschobene Halteschiene 7 horizontal und vertikal fixiert ist.

Die federnden Elemente 2 sind gemäß einer nicht dargestellten Ausführungsform an der Halteschiene 7 ausgebildet. An der Führungsschiene 1 sind an den Positionen, an denen federnde Elemente 2 an der Halteschiene 7 vorgesehen sind, nicht mehr notwendig.

An einem Ende der Führungsschiene 1 ist ein federnder Anschlag 11 ausgebildet. Am anderen Ende weist die Führungsschiene 1 eine Gegenrast 15 auf, die mit einem entsprechenden Rastmittel 12 an der Halteschiene 7 zusammenwirkt.

Der federnde Anschlag 11, das Rastmittel 12 und die Gegenrast 15 fixieren die Halteschiene 7 und damit eine Einschubbaugruppe 6 in Einschubrichtung.

Figur 2 zeigt die Seite der Führungsschiene 1, die im eingebauten Zustand an einem Einbaukäfig 5 anliegt.

Auf dieser Seite sind Zapfen 3 ausgebildet, mit denen die Halteschiene 7 in entsprechende Löcher 8 am Einbaukäfig 5 ansteckbar ist.

An der Außenseite der Zapfen 3 befinden sich in Längsrichtung angeordnete Rippen 4 , welche einen spielfreien Sitz der Führungsschiene 1 im Einbaukäfig 5 garantieren. Die Rippen 4 gleichen Ungenauigkeiten aus und werden beim Einstecken in die Bohrung zumindest teilweise verdrängt.

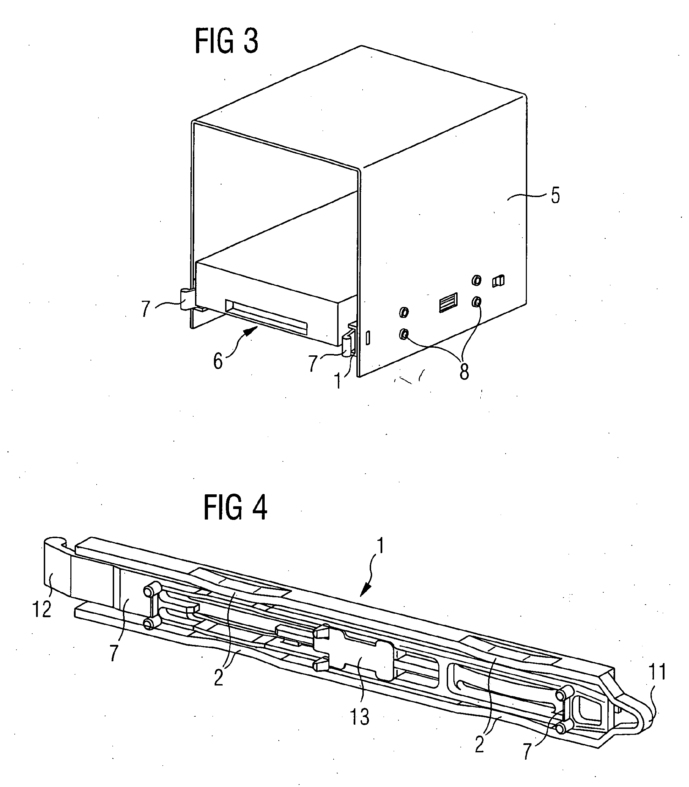

Figur 3 zeigt den Einbaukäfig 5 in den eine Einschubbaugruppe 6 mittels Halteschienen 7 und Führungsschienen 1 eingebaut ist.

An der Außenseite des Einbaukäfigs 5 stehen die Zapfen 3 aus den Löchern 8 hervor.

Figur 4 zeigt die Führungsschiene 1 gemäß Figur 1 mit eingeschobener Halteschiene 7.

Die Halteschiene 7 wird von den federnden Elementen 2, dem federnden Anschlag 11 und dem Zusammenwirken von Rastmittel 12 und Gegenrast 15 festgelegt.

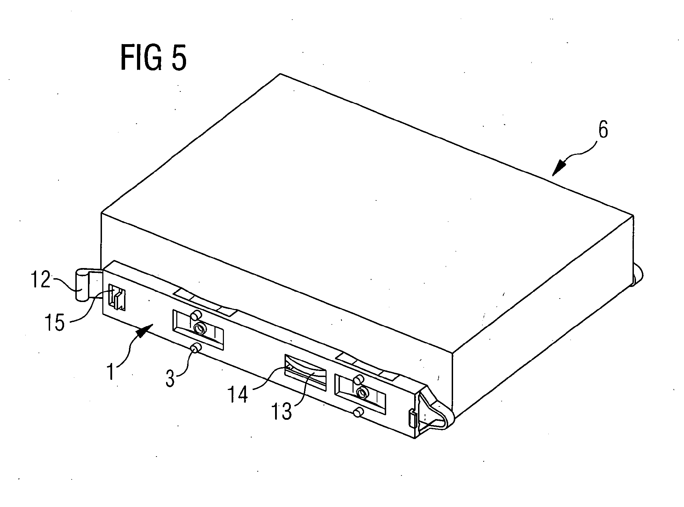

An der Halteschiene 7 befindet sich eine Kontaktfeder 13, die über ein Kontaktfenster 14 (siehe Figur 5) in der Führungsschiene 1 einen leitenden Kontakt zwischen Einschubbaugruppe 6 und Einbaukäfig 5 herstellt. Dadurch ist die Einschubbaugruppe geerdet.

Figur 5 zeigt die Einschubbaugruppe 6 auf die die Halteschiene 7 aufgesteckt ist und die in die Führungsschiene 1 eingeschoben ist.

Die Figur zeigt die Kontaktfeder 13 die aus dem Kontaktfenster 14 hervorsteht.

### Bezugszeichenliste

- 1: Führungsschiene
- 2: federnde Elemente
- 3: Zapfen
- 4: Rippen
- 5: Einbaukäfig
- 6: Einschubbaugruppe
- 7: Halteschienen
- 8: Löcher
- 9: äußere Schenkel
- 10: innere Schenkel
- 11: federnder Anschlag
- 12: Rastmittel
- 13: Kontaktfeder
- 14: Kontaktfenster
- 15: Gegenrast

## Patentansprüche

1. Anordnung zur Festlegung einer Einschubbaugruppe (6) in einem Einbaukäfig (5) eines Computers, mittels Halteschienen (7) aus Kunststoff, die seitlich an die Einschubbaugruppe (6) ansteckbar sind,
**dadurch gekennzeichnet, daß**
am Einbaukäfig (5) Führungsschienen (1) aus Kunststoff vorgesehen sind, in welche die Halteschienen (7) einsteckbar sind.

2. Anordnung nach Anspruch 1,
**dadurch gekennzeichnet, daß**
an den Führungsschienen (1) und/oder Halteschienen (7) federnde Elemente (2) ausgebildet sind.

3. Anordnung nach Anspruch 2,
**dadurch gekennzeichnet, daß**
die federnden Elemente (2) das Laufwerk horizontal und/oder vertikal festlegen.

4. Anordnung nach einem der Ansprüche 1 bis 3,
**dadurch gekennzeichnet, daß**
an einem Ende der Führungsschienen (1) federnde Anschläge (11) ausgebildet sind.

5. Anordnung nach Anspruch 4,
**dadurch gekennzeichnet, daß**
am anderen Ende der Führungsschienen (1) Gegenrasten (15) ausgebildet sind.

6. Anordnung nach Anspruch 5,
**dadurch gekennzeichnet, daß**
die Gegenrasten (15) im Zusammenwirken mit einem Rastmittel (12) und die federnden Anschläge (11) die Halteschienen (7) in Einschubrichtung festlegen.

7. Anordnung nach einem der Ansprüche 4 bis 6,
**dadurch gekennzeichnet, daß**
die federnden Elemente (2) und der federnde Anschlag (11) einstückig mit der Führungsschiene (1) ausgebildet sind.

8. Anordnung nach einem der Ansprüche 1 bis 7,
**dadurch gekennzeichnet, daß**
die Führungsschienen (1) und die Halteschienen (7) aus unterschiedlichen Kunststoffen hergestellt sind.

9. Anordnung nach einem der Ansprüche 1 bis 8,
**dadurch gekennzeichnet, daß**
die Führungsschienen (1) an der Außenseite Zapfen (3) aufweisen, mit welchen die Führungsschienen (1) in entsprechende Bohrungen (8) an dem Einbaukäfig (5) ansteckbar sind.

10. Anordnung nach Anspruch 9,
**dadurch gekennzeichnet, daß**
die Zapfen (3) an der Außenseite Rippen (4) aufweisen.

11. Anordnung nach einem der Ansprüche 1 bis 10, **dadurch gekennzeichnet, dass** die Führungsschienen (1) Kontaktfenster (14) aufweisen.
